# EUROPEAN PATENT APPLICATION

(11) **EP 2 178 203 A1**
(43) Date of publication of application: **21.04.2010**
(21) Application number: 08017958.3
(22) Date of filing: 14.10.2008
(51) Int. Cl.: H03F 1/02, H03F 3/217, H03F 3/68, H03F 3/189, H03F 1/32

(54) **Active antenna element for mobile radio communications**

(71) Applicant: Alcatel Lucent, 75008 Paris (FR)
(72) Inventor: Pascht, Andreas Dr., 73614 Schorndorf (DE); Wiegner, Dirk, 71409 Schwaikheim (DE)
(74) Representative: Kohler Schmid Möbus

(57) **Abstract**

The invention relates to an active antenna element (4a to 4d) for mobile radio communications, comprising: an amplifier module for amplifying a RF signal (6a to 6d) and an antenna (7) for transmitting the amplified RF signal (6a' to 6d'). The amplifier module is a class-S amplifier module (5) comprising a transistor switching stage (11) and a reconstruction filter (12). The invention also relates to a transmit frontend (1) for a base station comprising a plurality of such active antenna elements (4a to 4d), to a radio network (2) with at least one such transmit frontend (1), and to a method for amplifying a RF signal (6a to 6d) using such an active antenna element (4a to 4d).

## Description

### Background of the Invention

The invention relates to an active antenna element for mobile radio communications, comprising: an amplifier module for amplifying a RF signal and an antenna for transmitting the amplified RF signal. The invention also relates to a transmit fronted for a base station comprising a plurality of such active antenna elements, to a radio network comprising at least one base station with such a transmit frontend, and to a method for amplifying a RF signal in an active antenna element.

The invention relates to applications in mobile radio communications, more particularly to the transmit path of base stations, in particular of base transceiver stations (BTS). For radio transmission of a RF signal using an antenna, the RF signal has to be amplified at some location in the transmit path, typically in the transmit frontend of the BTS, However, instead of amplifying the RF signal in the transmit frontend of the BTS, it is also possible to equip the antenna elements of the BTS themselves with (active) amplification modules.

### Object of the Invention

It is the object of the invention to provide: an active antenna element, a transmit frontend for a base station comprising a plurality of such antenna elements, a radio network comprising at least one base station with such a transmit frontend, and a method for amplifying a RF signal in such an antenna element, all of which allowing to amplify RF signal with increased efficiency.

### Summary of the Invention

According to a first aspect, this object is met by an active antenna element as described in the introduction, wherein the amplifier module is a class-S amplifier module comprising a transistor switching stage and a reconstruction filter. Thus, the invention advantageously combines the active antenna approach with the promising class-S amplifier concept, i.e. the basic idea of the invention is to use highly efficient class-S based amplifiers in active antenna elements instead of e.g. class-AB amplifiers, Although it is known to use class-S amplifiers for audio applications, the use of class-S amplifiers for mobile radio applications, in particular in the context of active antenna elements, is a new and promising approach.

In a class-S amplifier module, a pulse-width or delta-sigma modulated signal is amplified in the transistor switching stage, and a reconstruction filter (typically a band-pass or low-pass filter) serves to eliminate unwanted spectral components, e.g. the switching frequency and its harmonics, from the amplified RF signal. As the RF signal to be amplified is typically a digital signal, a pulse-width or delta-sigma modulator may be arranged in the transmit path before the transistor switching stage.

In a preferred embodiment, the antenna element further comprises a feedback path from the output of the transistor switching stage to a pulse-width modulator or a delta-sigma modulator for self-linearization of the amplification. Linearization of the amplification within the class-S amplification module may be required, which may be performed e.g. by an appropriate adjustment of the pulse-width modulator or delta-sigma modulator using the pulse-width or delta-sigma modulated signal at the output of the transistor as a feedback signal, resulting in a kind of pre-distortion of the pulse-width or delta-sigma modulated RF signal at the input to the transistor switching stage which compensates the distortion caused by the amplification in the transistor switching stage.

In another preferred embodiment, the antenna element further comprises a feedback path from the output of the reconstruction filter to a digital pre-distortion unit for linearization of the amplification by digital pre-distortion of the RF signal. Digital pre-distortion (DPD) may be used to correct for the distortion caused in the amplifier module by pre-distorting the (digital) RF signal before the pulse-width or delta-sigma modulation in a way which reverses the distortion caused by the amplifier, resulting in an amplified RF signal at the output to the amplifier module which shows no or only little distortion. For performing the digital pre-distortion, the (analog) reconstructed signal at the output of the reconstruction filter, being no longer pulse-width or delta-sigma modulated, may be converted to a digital signal using an A/D-converter.

In a preferred embodiment, the class-S amplifier module comprises a pulse-width modulator or a delta-sigma modulator. In this case, all three elements of a typical class-S amplifier, namely the pulse-width modulator or delta-sigma modulator, the transistor switching stage and the reconstruction filter are combined in the active antenna element. The pulse-width modulator may be implemented as a digital device, or as an analog device, e.g. as an application-specific integrated circuit (ASIC).

In a preferred improvement, the antenna element further comprises a D/A-converter and a mixer at an input to the pulse-width or delta-sigma modulator of the class-S amplifier module, When an analog pulse-width modulator or delta-sigma modulator is used in the class-S amplifier module, D/A-conversion and typically also mixing (frequency conversion) of the digital RF signal transmitted from the baseband part is required.

Another aspect is implemented in a transmit frontend for a base station comprising a plurality of active antenna elements as described above. Typically, a base station comprises a transmit frontend with one or several antennas in an array arranged remotely from the baseband part. By parallelizing two or more antenna elements in an antenna array, power scalability and support of e.g. MIMO(multiple-input multiple-output)-schemes or spatial-forming can be achieved.

Preferably, the transmit frontend comprises a baseband part connected to the plurality of antenna elements, the baseband part comprising at least one digital pulse-width modulator or delta-sigma modulator. Such a modulator may be realized e.g. as a field programmable gate array (FPGA) in the baseband part, allowing to apply different delays to each class-S amplifier module in order to compensate e.g. for different delays of the active antenna elements.

A further aspect is implemented in a radio network comprising at least one base station with a transmit frontend as described above, the radio network advantageously using the high efficiency of the class-S amplifier modules of the antenna elements of the base station.

Yet another aspect is implemented in a method as described in the introduction, comprising: amplifying the RF signal in a transistor switching stage of a class-S amplifier module of the antenna element, thus increasing the efficiency of the amplification in the active antenna element.

A preferred variant includes: linearizing the amplification by using the amplified RF signal as a feedback signal. In case that the amplifier does not produce a linear output, the output signal from the transistor switching stage or from the reconstruction filter may be used as a feedback signal to compensate for distortions caused by the amplification.

In a highly preferred variant, the feedback signal is fed to a pulse-width modulator or to a delta-sigma modulator for self-linearization of the amplification. In this case, instead of performing the linearization by a pre-distortion of the digital RF signal, it is proposed to adapt the modulation characteristics of the pulse-width or delta-sigma modulator to generate a kind of pre-distorted pulse-width or delta-sigma modulated signal.

In another preferred variant, the feedback signal is fed to a digital pre-distortion unit for digital pre-distortion of the RF signal in order to achieve a linear amplification of the RF signal. It will be understood that although normally either digital pre-distortion or self-linearization is used for providing the linearization of the amplification, in certain applications, the two approaches may also be advantageously combined.

Further features and advantages are stated in the following description of exemplary embodiments, with reference to the figures of the drawing, which shows significant details, and are defined by the claims. The individual features can be implemented individually by themselves, or several of them can be implemented in any desired combination.

### Brief Description of the Drawings

Exemplary embodiments are shown in the diagrammatic drawing and are explained in the description below. The following are shown:
- **Fig. 1**: shows a schematic diagram of a first embodiment of a base station comprising exemplarily four active antenna elements with class-S amplifier modules, each comprising a pulse-width or delta-sigma modulator, and
- **Fig. 2**: shows a second embodiment of a base station with exemplarily three active antenna elements, a common pulse-width modulator of the class-S amplifier modules being arranged in a baseband part.

### Detailed Description of Preferred Embodiments

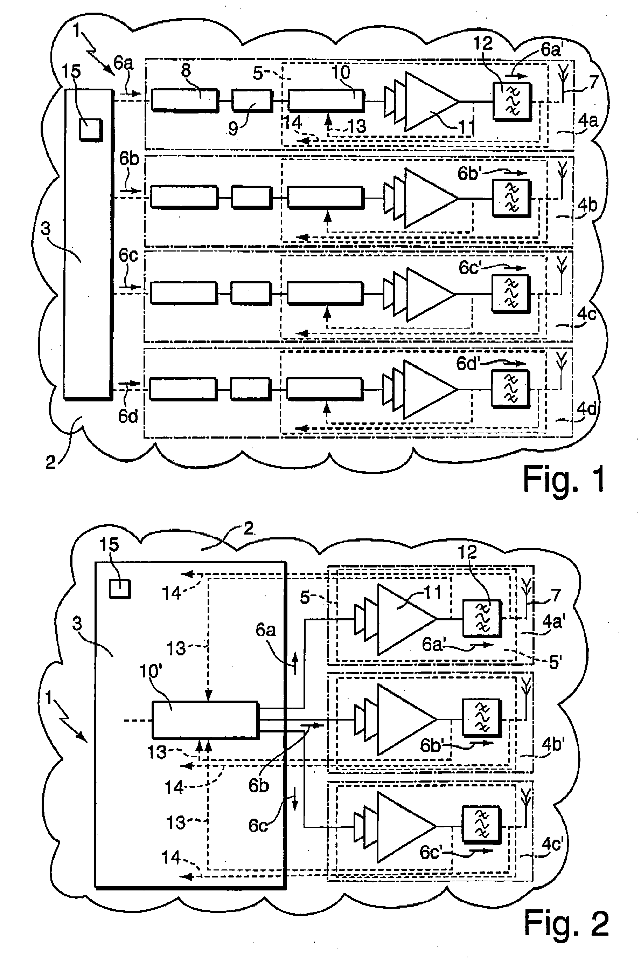

**Fig. 1** shows a transmit frontend **1** of a base station for mobile radio communications being part of a radio network **2.** The transmit frontend 1 may be implemented e.g. as a Node B when using the UMTS (universal mobile telecommunications) standard. The transmit frontend 1 comprises a baseband part **3** which is connected via cabling to four active antenna elements **4a** to **4d** being of identical construction. Each active antenna element 4a to 4d comprises a class-S amplifier module **5** for amplifying a respective RF signal **6a** to **6d**, and an antenna **7** for radio transmission of the respective amplified RF signal **6a'** to **6d'**. The array of four parallel antenna elements 4a to 4d may, for example, be used for supporting a MIMO scheme and shows increased power scalability.

In the following, the amplification of the first RF signal 6a which is provided as a digital signal from the baseband part 3 to the input of the first active antenna element 4a will be described in greater detail. In a first step, the first RF signal 6a is converted to an analog signal in a D/A-converter **8** of the first active antenna element 4a and subsequently frequency conversion is performed in a mixer **9** The input signal of the mixer 9 is on baseband RF level in the MHz range, the output signal of the mixer 9 is the addressed transmit RF frequency which is then fed to the class-S amplifier module 5.

The class-S amplifier module 5 comprises an analog modulator **10** in the form of a pulse-width modulator, a transistor switching stage **11,** and a reconstruction filter **12.** The person skilled in the art will appreciate that the modulator 10 may alternatively be implemented e.g. as an analog delta-sigma modulator. As usual in class-S amplifiers, the analog digital RF signal 6a is pulse-width or delta-sigma modulated in the modulator 10 and is then used to drive the transistor switching stage 11 at a switching frequency corresponding to the pulse frequency of the pulse-width or delta-sigma modulation. The reconstruction filter 12 is then used to filter unwanted spectral components, in particular the pulse frequency and its harmonics, out of the amplified RF signal 6a' and to generate an (analog) output signal which corresponds essentially to the RF input signal 6a. The person skilled in the art will appreciate that it is not necessary to devise the D/A-converter 8, the mixer 9 and the modulator 10 as separate components, as it is also possible to use an ASIC which integrates the functions of all three of these elements.

In case that the amplification of the RF signal 6a in the antenna element 4a is not performed in a linear way, it is possible to use the amplified RF signal 6a' at the output of the transistor switching stage 11 in a feedback path **13** to the modulator 10. In the modulator 10, the output of the transistor switching stage 11 may be used to generate a kind of pre-distortion of the pulse-width or delta-sigma modulated signal, thus enabling a self-linearization of the class-S amplifier module 5. Alternatively or in addition, a further feedback path **14** may be provided from the output of the reconstruction filter 12 to a digital pre-distortion unit **15** arranged in the baseband part 13 of the transmit frontend 1. The digital pre-distortion unit 15 is used for generating a pre-distortion of the digital RF signal 6a in the opposite way as compared to the distortion caused by the class-S module 5, such that the pre-distorted RF signal 6a may be amplified in a linear way in the class-S amplification module 5.

Whereas the transmit frontend 1 of Fig. 1 comprises analog class-S amplifier modules 5, **Fig. 2** shows an alternative way of implementing a transmit frontend 1 as a fully digital device up to the reconstruction filter 12. The transmit frontend 1 of Fig. 2 has exemplarily three active antenna elements **4a'** to **4c',** each of which comprises a class-S amplifier module **5'** with a transistor switching stage 11 and a reconstruction filter 12, all three antenna elements 4a' to 4c' sharing a common digital pulse-width or delta-sigma modulator block **10'** arranged in the baseband part 3 of the base station 1, being implemented as a FPGA. In this case, no D/A-converter is required, although also in this case, a mixer may be provided for frequency conversion, if e.g. the FPGA modulator 10' does not meet the bandwidth requirements. Using one modulator for all of the antenna elements 4a' to 4c' or more (synchronized) pulse-width or delta-sigma modulators in the modulator block 10' of the baseband part 3 allows to apply different delays to each Class-S amplifier module 5' in order to compensate e.g. different delays of the active antenna elements 4a' to 4c'. As is the case with the analog approach described with reference to Fig. 1, feedback paths 13, 14 may be provided, leading from the output of the transistor switching stage 11 or from the output of the reconstruction filter 12 to the pulse-width or delta-sigma modulator 10' or to the digital pre-distortion module 15, respectively.

The person skilled in the art will appreciate that as an alternative to the approach described with respect to Fig. 1, the pulse-width or delta-sigma modulator 10 of the Class-S amplifier module 5 may also be realized as a digital modulator which may be included in the active antenna elements 4a to 4d, being fed with a digital RF input signal 6a to 6c from the baseband part 3, thus also dispensing with the need for D/A-conversion. Moreover, it is also possible to combine antenna elements 4a to 4d of the type shown in Fig. 1 with antenna elements 4a' to 4c' of the type shown in Fig. 2 within the same base station, no additional modulator being required for the antenna elements 4a to 4d of Fig. 1 in the baseband part 3.

The use of class-S amplifier module(s) 5, 5' in the active antenna elements 4a to 4d, 4a' to 4c' allows increasing the efficiency of the power amplification and also the efficiency of the transmit frontend 1 e.g. by dropping the lossy cabling between power amplifier 5, 5' and antennas 7. Additionally, by combining several of the active antenna elements 4a to 4d, 4a' to 4c', high power scalability can be achieved and MIMO or spatial beam forming applications may be supported. Moreover, the approach described herein is flexible and applicable to different frequency bands and communication standards.

The above description of the preferred embodiments has been given by way of example. From the disclosure given, those skilled in the art will not only understand the present invention and its attendant advantages, but will also find apparent various changes and modifications to the structures and methods disclosed. The applicant seeks, therefore, to cover all such changes and modifications and equivalents thereof.

## Claims

1. An active antenna element (4a to 4d, 4a' to 4c') for mobile radio communications, comprising:
an amplifier module for amplifying a RF signal (6a to 6d), and
an antenna (7) for transmitting the amplified RF signal (6a' to 6d'),
**characterized in that**
the amplifier module is a class-S amplifier module (5, 5') comprising a transistor switching stage (11) and a reconstruction filter (12).

2. Antenna element according to claim 1, further comprising a feedback path (13) from the output of the transistor switching stage (11) to a pulse-width modulator (10) or a delta-sigma modulator (10') for self-linearization of the amplification.

3. Antenna element according to claim 1, further comprising a feedback path (14) from the output of the reconstruction filter (12) to a digital pre-distortion unit (15) for linearization of the amplification by digital pre-distortion of the RF signal (6a to 6d).

4. Antenna element according to claim 1, wherein the class-S amplifier module (5) comprises a pulse-width modulator (10) or a delta-sigma modulator.

5. Antenna element according to claim 4, further comprising a D/A-converter (8) and a mixer (9) at an input to the pulse-width modulator (10) or delta-sigma modulator of the class-S amplifier module (5).

6. Transmit frontend (1) for a base station comprising a plurality of active antenna elements (4a to 4d, 4a' to 4c') according to claim 1.

7. Transmit frontend according to claim 6, further comprising a baseband part (3) connected to the plurality of antenna elements (4a' to 4c'), the baseband part (3) comprising at least one digital pulse-width modulator (10) or delta-sigma modulator (10').

8. Radio network (2) comprising at least one base station with a transmit frontend (1) according to claim 7.

9. Method for amplifying a RF signal (6a to 6d) in an active antenna element (4a to 4d, 4a' to 4c'),
**characterized by**:
amplifying the RF signal (6a to 6d) in a transistor switching stage (11) of a class-S amplifier module (5, 5') of the antenna element (4a to 4d, 4a' to 4c').

10. Method according to claim 9, further comprising: linearizing the amplification by using the amplified RF signal (6a' to 6d') as a feedback signal.

11. Method according to claim 10, wherein the feedback signal (6a' to 6d') is fed to a pulse-width modulator (10) or a delta-sigma modulator (10') for self-linearization of the amplification.

12. Method according to claim 10, wherein the feedback signal (6a' to 6d') is fed to a digital pre-distortion unit (15) for linearizing the amplification by digital pre-distortion of the RF signal (6a to 6d).

## Amended claims

### Amended claims in accordance with Rule 137(2) EPC.

**1.** A transmit frontend (1) for a base station, the transmit frontend (1) comprising a baseband part (3) connected via cabling to a plurality of active antenna elements (4a to 4d, 4a' to 4c') for radio communications, the active antenna elements (4a to 4d, 4a' to 4c') comprising:
an amplifier module for amplifying a RF signal (6a to 6d), and
an antenna (7) for transmitting the amplified RF signal (6a' to 6d'),
**characterized in that**
the amplifier module is a class-S amplifier module (5, 5') comprising a transistor switching stage (11) and a reconstruction filter (12), and **in that** either the class-S amplifier module (5) or the baseband part (3) further comprises a pulse-width modulator (10) or a delta-sigma modulator (10') for modulating the RF signal (6a to 6d) prior to amplification.

**2.** Transmit frontend according to claim 1, further comprising a feedback path (13) from the output of the transistor switching stage (11) to the pulse-width modulator (10) or the delta-sigma modulator (10') for self-linearization of the amplification.

**3.** Transmit frontend according to claim 1, further comprising a feedback path (14) from the output of the reconstruction filter (12) to a digital pre-distortion unit (15) for linearization of the amplification by digital pre-distortion of the RF signal (6a to 6d).

**4.** Transmit frontend according to claim 1, further comprising a D/A-converter (8) and a mixer (9) at an input to the pulse-width modulator (10) or delta-sigma modulator of the class-S amplifier module (5).

**5.** Radio network (2) comprising at least one base station with a transmit frontend (1) according to claim 1.

**6.** Method for amplifying a RF signal (6a to 6d) in an active antenna element (4a to 4d, 4a' to 4c') of a transmit frontend (1),
**characterized by**:
amplifying the RF signal (6a to 6d) in a transistor switching stage (11) of a class-S amplifier module (5, 5') of the active antenna element (4a to 4d, 4a' to 4c') of the transmit frontend (1), and modulating the RF signal (6a to 6d) prior to amplification in a pulse-width modulator (10, 10') or in a delta-sigma modulator arranged in the class-S amplifier module (5, 5') or in a baseband part (3) of the transmit frontend (1).

**7.** Method according to claim 6, further comprising: linearizing the amplification by using the amplified RF signal (6a' to 6d') as a feedback signal.

**8.** Method according to claim 7, wherein the feedback signal (6a' to 6d') is fed to the pulse-width modulator (10) or the delta-sigma modulator (10') for self-linearization of the amplification.

**9.** Method according to claim 7, wherein the feedback signal (6a' to 6d') is fed to a digital pre-distortion unit (15) for linearizing the amplification by digital pre-distortion of the RF signal (6a to 6d).
